# EUROPEAN PATENT APPLICATION

(11) **EP 4 807 921 A1**
(43) Date of publication of application: **16.09.2026**
(21) Application number: 24888359.7
(22) Date of filing: 30.08.2024
(51) Int. Cl.: H01S 5/11, H01S 5/183

(54) **TWO-DIMENSIONAL PHOTONIC CRYSTAL SURFACE EMITTING LASER**

(30) Priority: 10.11.2023 JP 2023192341
(71) Applicant: Kyoto University, Kyoto-shi, Kyoto 606-8501 (JP)
(72) Inventor: NODA, Susumu, Kyoto-shi, Kyoto 606-8501 (JP); INOUE, Takuya, Kyoto-shi, Kyoto 606-8501 (JP); DE ZOYSA, Menaka, Kyoto-shi, Kyoto 606-8501 (JP); YOSHIDA, Masahiro, Kyoto-shi, Kyoto 606-8501 (JP); ISHIZAKI, Kenji, Kyoto-shi, Kyoto 606-8501 (JP)
(74) Representative: Hoeger, Stellrecht & Partner Patentanwälte mbB
(86) International application number: PCT/JP2024/031248
(87) International publication number: WO 2025/100057

(57) **Abstract**

A two-dimensional photonic crystal surface emitting laser (10) includes: a plurality of active layers (111, 112); a p-type cladding layer (13P) and an n-type cladding layer (13N); a tunnel junction layer (14) formed by a p-type tunnel junction layer (14P) and an n-type tunnel junction layer (14N) which are provided between each neighboring pair of layers among the plurality of active layers; a two-dimensional photonic crystal layer (12) provided between the p-type cladding layer and the n-type cladding layer; and a pair of electrodes (191, 192). The distance between the p-type cladding layer and the n-type cladding layer as well as the material of each of the aforementioned layers are set so that light having a predetermined frequency is confined between the p-type cladding layer and the n-type cladding layer as well as forms a higher-order vertical mode field distribution having the same number of nodes as the number of tunnel junction layers. Each of the tunnel junction layers is located at a position closer to a node between the p-type cladding layer and the n-type cladding layer than to an antinode of the higher-order vertical mode field distribution.

## Description

### TECHNICAL FIELD

The present invention relates to a two-dimensional photonic crystal surface emitting laser which is a type of semiconductor laser.

### BACKGROUND ART

A two-dimensional photonic crystal surface emitting laser (for example, see Patent Literature 1) normally includes an active layer, a two-dimensional photonic crystal layer, and a pair of cladding layers between which the two aforementioned layers are sandwiched, as well as a pair of electrodes ("electrode pair") between which the previously mentioned elements are sandwiched. The active layer generates light having a specific emission wavelength band by being injected with carriers (positive holes and electrons) from the electrode pair. The two-dimensional photonic crystal layer has a configuration including a plate-shaped base body in which modified refractive index areas having a refractive index different from that of the base body are periodically arranged in a two-dimensional form. The modified refractive index areas are formed by holes or irregularities (both of which are formed by air) created in the base body or members made of a material whose refractive index is different from that of the material of the base body.

In such a two-dimensional photonic crystal surface emitting laser, only a component of light having a predetermined wavelength corresponding to the period length of the arrangement of the modified refractive index areas is amplified in the two-dimensional photonic crystal layer and undergoes laser oscillation among the components of light generated in the active layer, and a laser beam is emitted from the surface the two-dimensional photonic crystal layer. The cladding layers, due to their difference in refractive index from the other layers, have the function of confining the light generated within the active layer and introducing it into the two-dimensional photonic crystal layer while allowing the laser beam to pass through.

It should be noted that the predetermined wavelength in the present context is the wavelength in the two-dimensional photonic crystal layer (hereinafter denoted by *λ*_{PC}). Let *n*_{eff} denote the effective refractive index determined by the refractive indices of the base body and the modified refractive index areas as well as their area ratio in the two-dimensional photonic crystal layer, and let also *λ*₀ denote the wavelength in an area outside the two-dimensional photonic crystal surface emitting laser (in the air; strictly, the refractive index is slightly larger than one, but an approximate value of one is used here). Then, *λ*_{PC}=*λ*₀/*n*_{eff}. Thus, while the wavelength varies depending on the position (refractive index), the frequency is independent of the position. Therefore, in the following description of the present invention, frequencies are also used as needed.

In an edge emitting laser (EEL) or vertical cavity surface emitting laser (VCSEL), both of which are representative semiconductor lasers, light is repeatedly reflected at both ends of a resonator and is thereby made to travel back and forth in a one-dimensional way. During this process, the light is intensified and amplified by interference. In contrast, in the two-dimensional photonic crystal surface emitting laser, the two-dimensionally arranged modified refractive index areas cause the traveling direction of the light to change not only to a 180-degree direction (in the case of reflection) but also to a 90-degree direction, whereby the light is intensified and amplified by interference while traveling in a two-dimensional way. This enables the two-dimensional photonic crystal surface emitting laser to produce a laser beam with a higher amount of power (intensity) than the EEL or VCSEL.

### CITATION LIST

### PATENT LITERATURE

Patent Literature 1: JP 2000-332351 A

### SUMMARY OF INVENTION

### TECHNICAL PROBLEM

In the area of machining in which the cutting, grinding or similar type of processing is performed on a workpiece, there is a demand for a laser which can continuously emit a high-power laser beam for performing those types of processing by means of a laser beam. On the other hand, in the area of sensing for detecting an object or human being, there is a demand for a pulse laser which can instantaneously emit a high-power laser beam in order to improve its sensitivity. Two-dimensional photonic crystal surface emitting lasers can emit both a continuous laser beam and a pulsed laser beam by controlling the electric current introduced between the electrodes. However, an additional improvement is required in order to further increase the power of those beams.

The problem to be solved by the present invention is to provide a two-dimensional photonic crystal surface emitting laser which can generate a laser beam with high power.

### SOLUTION TO PROBLEM

The two-dimensional photonic crystal surface emitting laser according to the present invention developed for solving the previously described problem is characterized by:
a) a plurality of active layers arranged separately from each other in the thickness direction, each of the active layers configured to emit light which covers a frequency band including a predetermined frequency by being injected with an electric current;
b) a p-type cladding layer made of a p-type semiconductor and an n-type cladding layer made of an n-type semiconductor, with the plurality of active layers sandwiched in between;
c) a tunnel junction layer provided between each neighboring pair of layers among the plurality of active layers, the tunnel junction layer formed by a p-type tunnel junction layer and an n-type tunnel junction layer, where the p-type tunnel junction layer is made of a p-type semiconductor having a higher carrier concentration than the p-type semiconductor forming the p-type cladding layer, and the n-type tunnel junction layer is made of an n-type semiconductor joined to a p-type-cladding-layer side of the p-type tunnel junction layer and having a higher carrier concentration than the n-type semiconductor forming the n-type cladding layer;
d) a two-dimensional photonic crystal layer provided between the p-type cladding layer and the n-type cladding layer, the two-dimensional photonic crystal layer including a plate-shaped base body in which modified refractive index areas which are areas having a refractive index different from the refractive index of the base body are arranged, where the modified refractive index areas are periodically arranged in a two-dimensional form with a period corresponding to the wavelength of the light having the predetermined frequency in the two-dimensional photonic crystal layer; and
e) a pair of electrodes between which the p-type cladding layer and the n-type cladding layer are sandwiched,
where:
f) the distance between the p-type cladding layer and the n-type cladding layer as well as the material of each of the aforementioned layers are set so that the light having the predetermined frequency forms a higher-order vertical mode field distribution which is confined between the p-type cladding layer and the n-type cladding layer and has the same number of nodes as the number of tunnel junction layers; and
g) each of the tunnel junction layers is located at a position closer to a node between the p-type cladding layer and the n-type cladding layer than to an antinode of the higher-order vertical mode field distribution.

In the two-dimensional photonic crystal surface emitting laser according to the present invention, when voltage is applied between the pair of electrodes, electrons are introduced from the n-type cladding layer into the active layer closest to that n-type cladding layer among the plurality of active layers (that layer is hereinafter called the "first active layer"). Since there is a tunnel junction layer between the first active layer and the neighboring active layer ("second active layer"), the electrons are further introduced from the first active layer into the second active layer through that tunnel junction layer. Through the repetition of this process, electrons are introduced into all of the first through M+1^{st} active layers forming the plurality of active layers (whose number is assumed to be M+1, where M is a natural number). In a similar manner, positive holes are initially introduced into the M+1^{st} active layer closest to the p-cladding layer and are further introduced into the M^{th} through the first active layers through the tunnel junction layers.

With the electrons and positive holes thus introduced into all of the plurality of active layers, light which covers a frequency band including the predetermined frequency is generated in each active layer. This light enters the two-dimensional photonic crystal layer. In the two-dimensional photonic crystal layer, due to the modified refractive index areas which are arranged with a period corresponding to the wavelength which the light having the predetermined frequency will have in the same layer, the light having the predetermined frequency is selectively amplified. Laser light having the predetermined frequency is consequently generated, and a laser beam is produced in a direction perpendicular to the two-dimensional photonic crystal layer.

Here, the p-type cladding layer and the n-type cladding layer have the function of confining the light generated within the active layer and introducing it into the two-dimensional photonic crystal layer while allowing the laser beam to pass through. On the other hand, due to the presence of the p-type cladding layer and the n-type cladding layer, the light which is present between these two layers has a field distribution of a fundamental vertical mode having a single antinode or a higher-order vertical mode having a plurality of antinodes and one or more nodes whose number is smaller than that of the antinodes by one. In any of these modes, the electric field within the p-type cladding layer and the n-type cladding layer is dampened toward the outside (in the direction opposite from the side where the active layer, two-dimensional photonic crystal layer, tunnel junction layer and the likes are located as viewed from those cladding layers), being confined between the p-type cladding layer and the n-type cladding layer. The antinodes and the nodes of the resulting field distribution are determined by the wavelength (frequency) of the light as well as the distance between the p-type cladding layer and the n-type cladding layer and the material (refractive index) of each layer located between the two cladding layers.

The tunnel junction layer has the characteristic that it absorbs light more easily than the p-type cladding layer and the n-type cladding layer since it has a higher carrier concentration. Therefore, if the position of the tunnel junction layer coincides with that of an antinode in the field distribution, a portion of the light generated in the active layer will be easily absorbed by the tunnel junction layer, causing a decrease in the intensity of the light to be introduced into the two-dimensional photonic crystal layer.

Therefore, the present invention additionally requires that the distance between the p-type cladding layer and the n-type cladding layer as well as the material of each layer should be set or selected so that the light having the predetermined frequency will form a higher-order vertical mode field distribution having the same number of nodes (M) as the tunnel junction layers between the p-type cladding layer and the n-type cladding layer, with each tunnel junction layer located at a position close to the corresponding node. This configuration can suppress the absorption in the tunnel junction layers of the light generated in each of the plurality of active layers, thereby making it possible to assuredly produce a laser beam with a higher amount of power than in the case where the light generated in a single active layer is amplified by a two-dimensional photonic crystal.

The distance between the p-type cladding layer and the n-type cladding layer in the present context can be defined, for example, as the distance between the inner surfaces of those two layers (the surfaces facing the region in which the active layers, two-dimensional photonic crystal layer, tunnel junction layers and the likes are located). It should be noted that the electric field is not always at zero at positions on the inner surfaces of those layers; the electric field normally becomes zero at positions inside the p-type cladding layer and the n-type cladding layer.

In the two-dimensional photonic crystal surface emitting laser according to the present invention, if two or more two-dimensional photonic crystal layers are provided, laser oscillations with their phases shifted from each other may independently occur in the two-dimensional photonic crystal layers, respectively. Therefore, it is preferable to provide a single two-dimensional photonic crystal layer in the two-dimensional photonic crystal surface emitting laser according to the present invention. The two-dimensional photonic crystal layer may be located at any position between the p-type cladding layer and the n-type cladding layer. That is to say, the two-dimensional photonic crystal layer may be located between the n-type cladding layer and the active layer closest to that cladding layer, or between the p-type cladding layer and the active layer closest to that cladding layer, or between one of the active layers and the tunnel junction layer closest to that active layer.

Preferably, the two-dimensional photonic crystal surface emitting laser according to the present invention should further include a spacer layer located at least at one of the interspaces between the active layers and the tunnel junction layers. This prevents the light generated in the active layers from being directly absorbed into the tunnel junction layers. The material (refractive index) and the thickness of the spacer layer can be adjusted so that the light having the predetermined frequency forms a higher-order vertical mode field distribution having the same number of nodes as the tunnel junction layers. In this case, the refractive index of the spacer layer should preferably be higher than the refractive indices of the p-type cladding layer and the n-type cladding layer. This prevents the intensity of light from being completely dampened within the interspaces between the active layers and the tunnel junction layers, which enables the formation of a single vertical mode field distribution over the entirety of the layering direction rather than independent vertical mode field distributions each of which surrounds one of the active layers. If an independent vertical mode field distribution surrounding an active layer was formed at each of the active layers, only the light generated at positions closest to the two-dimensional photonic crystal layer could be amplified. By forming a single vertical mode field distribution over the entirety of the layering direction, the light generated in all active layers can be amplified in the two-dimensional photonic crystal layer.

A spacer layer may additionally be provided at a position other than the interspaces between the active layers and the tunnel junction layers. Such a spacer layer allows for the adjustment of the positional relationship between the tunnel junction layers and the nodes of the higher-order vertical mode field distribution formed by light between the p-type cladding layer and the n-type cladding layer. The spacer layer may be made of any material, although it is preferable to use a material having a lower carrier concentration in order to suppress the absorption of light in this spacer layer.

In the two-dimensional photonic crystal surface emitting laser according to the present invention, the plurality of active layers should preferably be made of the same material and have the same thickness. This prevents the situation in which only some of the active layers (i.e., active layers having a larger thickness than the other layers) are in a high-gain state while the other active layers are in a light-absorbing state.

In the two-dimensional photonic crystal surface emitting laser according to the present invention, a tunnel junction layer that is too thin will not satisfactorily function as a tunnel junction and may be unable to supply electrons and positive holes to all active layers. On the other hand, a tunnel junction layer that is too thick will easily absorb light and thereby decrease the intensity of the light to be introduced into the two-dimensional photonic crystal layer. Considering these factors, the thickness of each tunnel junction layer (the total thickness of the p-type tunnel junction layer and the n-type tunnel junction layer) should preferably be within a range from 10 to 200 nm.

### ADVANTAGEOUS EFFECTS OF INVENTION

According to the present invention, a two-dimensional photonic crystal surface emitting laser which can generate a laser beam with high power can be obtained.

### BRIEF DESCRIPTION OF DRAWINGS

[Fig. 1] A vertical sectional view showing the first embodiment of the two-dimensional photonic crystal surface emitting laser according to the present invention.
[Fig. 2] A plan view showing the two-dimensional photonic crystal layer in the two-dimensional photonic crystal surface emitting laser according to the first embodiment.
[Fig. 3] A plan view showing (a) a first electrode and (b) a second electrode in the two-dimensional photonic crystal surface emitting laser according to the first embodiment, as well as (c) a first electrode and (d) a second electrode in a modified example.
[Fig. 4] A graph showing the result of a calculation of the field intensity distribution of light within the device in the two-dimensional photonic crystal surface emitting lasers according to the first embodiment and two comparative examples.
[Fig. 5] A graph showing the result of a calculation of the relationship between the amount of injected electric current and the power of the laser light for the two-dimensional photonic crystal surface emitting lasers according to the first embodiment and a comparative example.
[Fig. 6] Micrographs of an actually created two-dimensional photonic crystal surface emitting laser according to the first embodiment, showing (a) a portion of a vertical section of the two-dimensional photonic crystal surface emitting laser and (b) a portion of the upper surface of the two-dimensional photonic crystal layer.
[Fig. 7] A graph showing the refractive index and calculated results of the field intensity distribution of light in the actually created two-dimensional photonic crystal surface emitting laser according to the first embodiment, with an electron micrograph of the vertical section attached for comparison.
[Fig. 8] A graph showing the result of an experiment in which the relationship between the amount of injected electric current and the power of laser light was determined for two-dimensional photonic crystal surface emitting lasers actually created according to the first embodiment and a comparative example.
[Fig. 9] A vertical sectional view showing another embodiment of the two-dimensional photonic crystal surface emitting laser according to the present invention.
[Fig. 10] A graph showing the result of a calculation of the field intensity distribution of light and the distribution of the refractive index within the device in the two-dimensional photonic crystal surface emitting laser according to the embodiment of Fig. 9.

### DESCRIPTION OF EMBODIMENTS

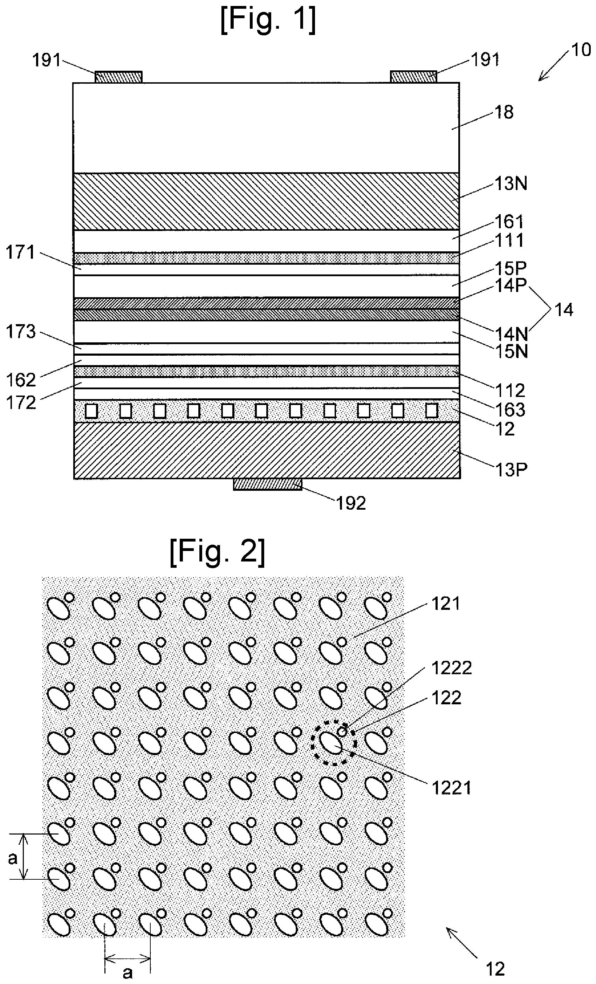

Embodiments of the two-dimensional photonic crystal surface emitting laser according to the present invention will be described using Figs. 1-10.

### (1) Configuration of two-dimensional photonic crystal surface emitting laser according to first embodiment

Fig. 1 shows a vertical sectional view of a two-dimensional photonic crystal surface emitting laser 10 which is the first embodiment of the two-dimensional photonic crystal surface emitting laser according to the present invention. In this figure, the thickness direction (the vertical direction in the figure) is expanded for the visibility of the structure of the stacked layers (which will be described later). An actual two-dimensional photonic crystal surface emitting laser 10 has a significantly larger size in the in-plane direction than in the thickness direction.

The two-dimensional photonic crystal surface emitting laser 10 according to the first embodiment has a laminated structure in which the following components are arranged in this order: a first electrode 191, a substrate 18, an n-type cladding layer 13N, a first spacer layer 161, a first active layer 111, a first electron-blocking layer 171, a spacer layer 15P between an active layer and a p-type tunnel junction layer, a p-type tunnel junction layer 14P, an n-type tunnel junction layer 14N, a spacer layer 15N between an active layer and an n-type tunnel junction layer, a positive-hole-blocking layer 173, a second spacer layer 162, a second active layer 112, a second electron-blocking layer 172, a third spacer layer 163, a two-dimensional photonic crystal layer 12, a p-type cladding layer 13P and a second electrode 192. The combination of the p-type tunnel junction layer 14P and the n-type tunnel junction layer 14N is called the "tunnel junction layer 14".

It should be noted that the spacer layer 15P between an active layer and a p-type tunnel junction layer, the spacer layer 15N between an active layer and an n-type tunnel junction layer, as well as the first spacer layer 161, second spacer layer 162, third spacer layer 163, first electron-blocking layer 171, second electron-blocking layer 172 and positive-hole-blocking layer 173 may be omitted. The substrate 18 may also be omitted if the mechanical strength of the device can still be maintained.

Both the first active layer 111 and the second active layer 112 are configured to emit light having a predetermined wavelength band by being injected with carriers (electrons and positive holes). As for the material of the first active layer 111 and the second active layer 112, an InGaAs/AlGaAs multiple quantum well (with an emission frequency band of 3.17×10¹⁴ to 3.21×10¹⁴ sec⁻¹, which corresponds to an emission wavelength band of 935 to 945 nm as expressed in the wavelength in the air) is used for both layers in the first embodiment. It is preferable that the first active layer 111 and the second active layer 112 be made of the same material, as in the present case. It is further preferable that they have the same thickness. Giving the same material and thickness prevents the situation in which either the first active layer 111 or the second active layer 112 becomes in a higher-gain state than the other layer while this other active layer becomes in a light-absorbing state when they are injected with carriers.

As shown in Fig. 2, the two-dimensional photonic crystal layer 12 consists of a plate-shaped base body 121 in which a plurality of modified refractive index areas 122 which are areas having a refractive index different from that of the base body are periodically arranged. In the first embodiment, the modified refractive index areas 122 are arranged in a square lattice form. As for the material of the base body 121, GaAs (which may be a p-type semiconductor or an intrinsic semiconductor) is used in the first embodiment, while holes (air) are used as the modified refractive index areas 122. The modified refractive index areas 122 may also be created by forming irregularities on the surface of the base body 121 or embedding, in the base body 121, members made of a material having a refractive index different from that of the base body 121, in place of the holes. The shape of each modified refractive index area 122 in the first embodiment is the combination of a first modified refractive index area 1221 having an elliptic shape and a second modified refractive index area 1222 having a circular shape whose area is smaller than the first modified refractive index area 1221. It should be noted that the present invention has no specific requirement concerning the shape of the modified refractive index areas 122.

The period length of the arrangement of the modified refractive index areas 122 (the lattice constant of the square lattice), *a*, in the first embodiment is 276 nm. Under the condition that the predetermined frequency mentioned earlier is 3.19×10¹⁴ sec⁻¹ (which corresponds to a wavelength of 941.7 nm in the air) which is within the emission frequency band of the first active layer 111 and the second active layer 112, the aforementioned period length corresponds to the predetermined frequency of light in the two-dimensional photonic crystal layer 12. The wavelength in the two-dimensional photonic crystal layer 12 depends on the effective refractive index of the two-dimensional photonic crystal layer 12 (in the first embodiment, 3.412). This effective refractive index depends on the material of the base body 121 and that of the modified refractive index areas 122 as well as the ratio of the area occupied by the base body 121 and that occupied by the modified refractive index areas 122.

Although the first embodiment assumes that the position of the two-dimensional photonic crystal layer 12 in the thickness direction is between the second active layer 112 and the p-type cladding layer 13P, that layer may be located at any position. For example, it may be located between the n-type cladding layer 13N and the first active layer 111, or between the first active layer 111 and the tunnel junction layer 14, or between the second active layer 112 and the tunnel junction layer 14 (although the omittable layers, i.e., the high refractivity spacer layers, spacer layers and electron-blocking layers, are not included in the foregoing description, the two-dimensional photonic crystal layer 12 may also be in any positional relationship with those spacer layers and electron-blocking layers). When an extrinsic semiconductor is used as the material of the base body 121, the type of semiconductor depends on the position at which the two-dimensional photonic crystal layer 12 is located; i.e., an n-type semiconductor should be used if the carriers which pass through that position are mainly electrons, while a p-type semiconductor should be used if those carriers are mainly positive holes. When an intrinsic semiconductor is used, the type of semiconductor does not depend on the position of the two-dimensional photonic crystal layer 12.

The n-type cladding layer 13N and the p-type cladding layer 13P are provided so that layers other than the first electrode 191 and the second electrode 192 are sandwiched in between in the thickness direction. The n-type cladding layer 13N, which is made of an n-type semiconductor, has the function of injecting electrons from the first electrode 191 as well as the function of confining light generated in the first active layer 111 and the second active layer 112 and introducing it into the two-dimensional photonic crystal layer 12 while allowing a laser beam generated in the two-dimensional crystal layer 12 to pass through. The p-type cladding layer 13P, which is made of a p-type semiconductor, has the function of injecting positive holes from the second electrode 192 as well as the function of confining light generated in the first active layer 111 and the second active layer 112 and introducing it into the two-dimensional photonic crystal layer 12. In the first embodiment, n-type AlGaAs is used as the material of the n-type cladding layer 13N, while p-type AlGaAs is used as the material of the p-type cladding layer 13P.

The tunnel junction layer 14, which consists of the p-type tunnel junction layer 14P and the n-type tunnel junction layer 14N joined together, is provided between the first active layer 111 and the second active layer 112. The p-type tunnel junction layer 14P is made of a p-type semiconductor having a higher positive-hole concentration than the p-type cladding layer 13P. The n-type tunnel junction layer 14N is made of an n-type semiconductor having a higher electron concentration than the n-type cladding layer 13N. In the first embodiment, p-type GaAs is used for the p-type tunnel junction layer 14P, while n-type GaAs is used for the n-type tunnel junction layer 14N.

This tunnel junction layer 14 has the function of introducing, into the second active layer 112, the electrons injected from the first electrode 191 and passing through the first active layer 111, as well as the function of introducing, into the first active layer 111, the positive holes injected from the second electrode 192 and passing through the second active layer 112. Among those carriers, the electrons are made to move in a direction in which they will not move at a normal PN junction. However, it is possible to induce electrons to move in such a direction by increasing the carrier concentration in the tunnel junction layer 14 as well as sufficiently reducing the thicknesses of the p-type tunnel junction layer 14P and the n-type tunnel junction layer 14N. To this end, it is preferable that the carrier concentration should be equal to or higher than 5.0×10¹⁸/cm³ in both the p-type tunnel junction layer 14P and the n-type tunnel junction layer 14N, and the entire thickness of the tunnel junction layer 14 should be within a range from 10 to 200 nm (with each of the p-type and n-type tunnel junction layers 14P and 14N having a thickness within a range from 5 to 100 nm). In the first embodiment, the carrier concentration in the p-type tunnel junction layer 14P is 4.0×10¹⁹/cm³, while the carrier concentration in the n-type tunnel junction layer 14N is 1.0×10¹⁹/cm³. The thickness of the p-type and n-type tunnel junction layers 14P and 14N is 50 nm each. It is also possible to give different thicknesses to the p-type tunnel junction layer 14P and the n-type tunnel junction layer 14N.

The spacer layer 15P between an active layer and a p-type tunnel junction layer, which is provided between the first active layer 111 and the p-type tunnel junction layer 14P, is made of a p-type semiconductor having a higher refractive index than the p-type cladding layer 13P. The spacer layer 15N between an active layer and an n-type tunnel junction layer, which is provided between the second active layer 112 and the n-type tunnel junction layer 14N, is made of an n-type semiconductor having a higher refractive index than the n-type cladding layer 13N. In the first embodiment, the material of the spacer layer 15P between an active layer and a p-type tunnel junction layer is p-type AlGaAs having a higher refractive index due to a lower composition ratio of Al than the p-type AlGaAs used as the material of the p-type cladding layer 13P (which is composed of the same kinds of elements as the material of the spacer layer 15P between an active layer and a p-type tunnel junction layer). Similarly, the material of the spacer layer 15N between an active layer and an n-type tunnel junction layer is n-type AlGaAs having a higher refractive index due to a lower composition ratio of Al than the n-type AlGaAs used as the material of the n-type cladding layer 13N. The spacer layer 15P between an active layer and a p-type tunnel junction layer and the spacer layer 15N between an active layer and an n-type tunnel junction layer respectively have the function of preventing light generated in the first active layer 111 and the second active layer 112 from being directly absorbed into the tunnel junction layer 14.

The first electron-blocking layer 171 is provided in contact with the first active layer 111 on the side directed to the second electrode 192. Similarly, the second electron-blocking layer 172 is provided in contact with the second active layer 112 on the side directed to the second electrode 192. Both the first electron-blocking layer 171 and the second electron-blocking layer 172 are made of a p-type semiconductor and are provided in order to impede the electrons introduced from the first electrode 191 into the first active layer 111 and the second active layer 112 from passing through the first active layer 111 and the second active layer 112, thereby increasing the emission intensity in the first active layer 111 and the second active layer 112. In the first embodiment, p-type AlGaAs is used as the material of the first electron-blocking layer 171 and the second electron-blocking layer 172.

The positive-hole-blocking layer 173 is provided on the same side as the first electrode 191 as viewed from the second active layer 112, with the second spacer layer 162 sandwiched in between. The positive-hole-blocking layer 173, which is made of an n-type semiconductor, is provided in order to impede the positive holes introduced from the second electrode 192 into the second active layer 112 from passing through the second active layer 112, thereby increasing the emission intensity in the second active layer 112. In the first embodiment, n-type AlGaAs is used as the material of the positive-hole-blocking layer 173. It should be noted that the positive-hole-blocking layer 173 may be omitted since the diffusion length of positive holes is shorter than that of electrons.

The substrate 18 is provided for maintaining the mechanical strength of the entire two-dimensional photonic crystal surface emitting laser 10 as well as adjusting the distribution of the current density in the first active layer 111 and the second active layer 112 formed by an electric current injected from the first electrode 191 and the second electrode 192, as will be described later. The thickness of the substrate 18 should be sufficiently larger than those of the layers described thus far. The material used for the substrate 18 is an n-type semiconductor having the same polarity as the n-type cladding layer 13N which is in contact with the base body. In the first embodiment, the substrate 18 has a thickness of 150 µm. The material of the substrate 18 is n-type GaAs.

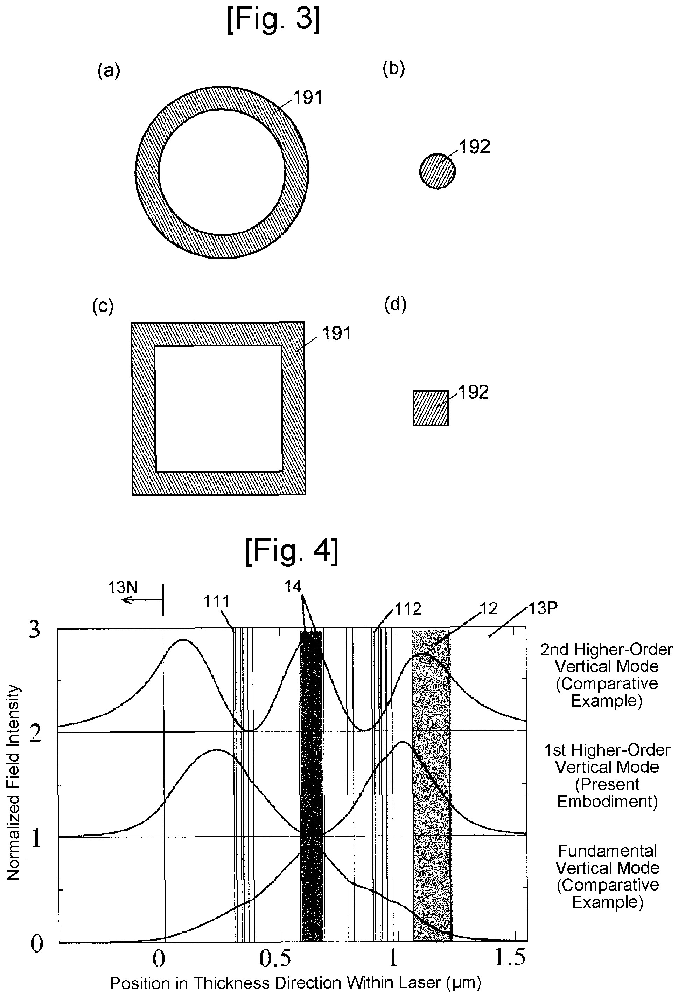

The first electrode 191 and the second electrode 192 are provided so that the previously described layers are sandwiched in between in the thickness direction. In the first embodiment, a ring-shaped electrode made of a conductive material is used as the first electrode 191 (Fig. 3(a)), while a circular electrode made of a conductive material is used as the second electrode 192 (Fig. 3(b)). The inner area of the ring of the first electrode 191 functions as a window which allows a beam of laser light generated in the two-dimensional photonic crystal layer 12 to pass through. The second electrode 192 is arranged within the inner area of the ring of the first electrode 191 in the direction parallel to the layers and is sufficiently smaller than the inner area of the same ring. Due to the first electrode 191 and the second electrode 192 shaped in this manner as well as the substrate being sufficiently thicker than the other layers as described earlier, the electric current injected from the first electrode 191 and the second electrode 192 can be focused into the vicinity of the center of the aforementioned ring in the direction parallel to the layers at around the positions of the first active layer 111 and the second active layer 112, and the distribution of the current density within that focused range can be approximately uniform.

It should be noted that an electrode in the form of a rectangular (square) frame (Fig. 3(c)) or other shapes may be used as the first electrode 191 in place of the ring. Similarly, a rectangular (square) electrode (Fig. 3(d)) or electrodes having other shapes may be used as the second electrode 192 in place of the circular electrode. As for the first electrode 191, an electrode which is transparent to the emitted laser light (or similar electrodes) may be used in place of the electrode having a window.

The first spacer layer 161, second spacer layer 162 and third spacer layer 163 all serve to adjust the distance between the n-type cladding layer 13N and the p-type cladding layer 13P. In the first embodiment, intrinsic AlGaAs is used as the material of the first through third spacer layers 161-163.

The distance between the n-type cladding layer 13N and the p-type cladding layer 13P was determined by calculating the thicknesses of the related layers by a simulation as follows: The simulation assumed that the layers made of the materials described thus far were stacked, and the thicknesses of those layers were set so that the light having the predetermined frequency mentioned earlier (3.19×10¹⁴ sec⁻¹) would form a first higher-order vertical mode field distribution in the thickness direction between the n-type cladding layer 13N and the p-type cladding layer 13P. An "M-th higher-order vertical mode field distribution" (where M is a natural number) is an electric field distribution of standing waves in which (the electric field of) light is confined between the n-type cladding layer 13N and the p-type cladding layer 13P, with M nodes (which is one in the case of the first higher-order vertical mode field distribution) formed between the n-type cladding layer 13N and the p-type cladding layer 13P. The setting in the simulation was also performed so that the tunnel junction layer 14 would be located at a position closer to a node than to an antinode in the first higher-order vertical mode field distribution. For comparison, for the case where the thicknesses of the related layers were set in the previously described manner, a calculation was performed to determine the wavelength of light at which the fundamental vertical mode field distribution (in which (the electric field) of light is confined between the n-type cladding layer 13N and the p-type cladding layer 13P, with no node formed in between) would be formed, and also to determine the wavelength of light at which the second (M=2) higher-order vertical mode field distribution would be formed.

The result of the simulation has revealed that, when the thicknesses of the layers are set as shown in Table 1, the light having the predetermined frequency will form the first higher-order vertical mode field distribution as shown in the calculated result in Fig. 4, with the tunnel junction layer 14 located at a position closer to a node than to an antinode in this field distribution. Furthermore, when the thicknesses of the layers are set in the aforementioned manner, the wavelength in the air of the fundamental vertical mode field distribution will be 12.9 nm longer than the wavelength of the first higher-order vertical mode field distribution, and the wavelength in the air of the second higher-order vertical mode field distribution will be 13.7 nm shorter than that. Accordingly, the light having the predetermined frequency (which corresponds to a wavelength of 941.7 nm in the air) is prevented from forming the fundamental vertical mode field distribution or the second higher-order vertical mode field distribution. With the tunnel junction layer 14 thus located at the node of the first higher-order vertical mode field distribution, the absorption in the tunnel junction layer 14 of light generated in the first active layer 111 and the second active layer 112 can be suppressed. Accordingly, in the first embodiment, the thicknesses of the layers were set as shown in Table 1.

**[Table 1]**

| | Thickness (nm) |
|---|---|
| n-type cladding layer 13N | 1000 |
| First spacer layer 161 | 300 |
| First active layer 111 | 80 |
| First electron-blocking layer 171 | 25 |
| Spacer layer between active layer and p-type tunnel junction layer, 15P | 200 |
| p-type tunnel junction layer 14P | 50 |
| n-type tunnel junction layer 14N | 50 |
| Spacer layer between active layer and n-type tunnel junction layer, 15N | 100 |
| Positive-hole-blocking layer 173 | 25 |
| Second spacer layer 162 | 80 |
| Second active layer 112 | 80 |
| Second electron-blocking layer 172 | 25 |
| Third spacer layer 163 | 90 |
| Two-dimensional photonic crystal layer 12 | 160 |
| p-type cladding layer 13P | 1000 |

### (2) Operation of two-dimensional photonic crystal surface emitting laser according to first embodiment

An operation of the two-dimensional photonic crystal surface emitting laser according to the first embodiment is hereinafter described. When this two-dimensional photonic crystal surface emitting laser 10 is in use, a voltage which is negative at the first electrode 191 and positive at the second electrode 192 is applied between the two electrodes. Electrons and positive holes are thereby introduced from the first electrode 191 and the second electrode 192, respectively.

The electrons introduced from the first electrode 191 pass through the substrate 18 (which is made of an n-type semiconductor), n-type cladding layer 13N and first spacer layer 161, to be introduced into the first active layer 111. A portion of the electrons passes through the active layer 111 and further passes through the first electron-blocking layer 171, the spacer layer 15P between an active layer and a p-type tunnel junction layer, as well as the tunnel junction layer 14 due to the voltage which is positive at the second electrode 192. The electrons which have passed through the tunnel junction layer 14 further pass through the spacer layer 15N (which is made of an n-type semiconductor) between an active layer and an n-type tunnel junction layer, the positive-hole-blocking layer 173 and the second spacer layer 162, to be introduced into the second active layer 112.

On the other hand, the positive holes introduced from the second electrode 192 pass through the p-type cladding layer 13P (which is made of a p-type semiconductor), the base body 121 of the two-dimensional photonic crystal layer 12, the third spacer layer 163 and the second electron-blocking layer 172, to be introduced into the second active layer 112. A portion of the positive holes passes through the second active layer 112 and further passes through the second spacer layer 162, the positive-hole-blocking layer 173, the spacer layer 15N between an active layer and an n-type tunnel junction layer, as well as the tunnel junction layer 14 due to the voltage which is negative at the first electrode 191. The positive holes which have passed through the tunnel junction layer 14 further pass through the spacer layer 15P (which is a p-type semiconductor) between an active layer and a p-type tunnel junction layer as well as the first electron-blocking layer 171, to be introduced into the first active layer 111.

Thus, electrons and positive holes are introduced into both the first active layer 111 and the second active layer 112, whereby light which covers a frequency band including the predetermined frequency is generated. The electric field of the light having the predetermined frequency generated in each of the first and second active layers 111 and 112 forms a first higher-order vertical mode of standing waves in the thickness direction. As illustrated in Fig. 4, in the tunnel junction layer 14, the standing waves are located closer to a node than to an antinode. Therefore, the absorption of light in the tunnel junction layer 14 which has a high carrier concentration is suppressed.

The resulting light having the predetermined frequency is amplified in the two-dimensional photonic crystal layer 12 and undergoes laser oscillation. The laser beam resulting from the laser oscillation passes through the layers between the two-dimensional photonic crystal layer 12 and the first electrode 191 and exits from the window of the first electrode 191 to the outside of the two-dimensional photonic crystal surface emitting laser 10.

The two-dimensional photonic crystal surface emitting laser 10 according to the first embodiment generates strong light by introducing electrons and positive holes into two active layers (the first active layer 111 and the second active layer 112) rather than a single active layer, and amplifies that light by means of the two-dimensional photonic crystal layer 12, thereby producing a laser beam with a higher amount of power than conventional two-dimensional photonic crystal surface emitting lasers. Since the tunnel junction layer 14 is located at a position closer to a node than to an antinode of the first higher-order vertical mode which is a mode of standing waves of the electric field of light formed within the two-dimensional photonic crystal surface emitting laser 10, the absorption of light in the tunnel junction layer 14 which has a high carrier concentration can be suppressed. This also contributes to the effect of producing a laser beam with a higher amount of power.

Furthermore, in the two-dimensional photonic crystal surface emitting laser 10 according to the first embodiment, since the spacer layer 15P between an active layer and a p-type tunnel junction layer, which has a higher refractive index than the p-type cladding layer 13P, is provided between the first active layer 111 and the tunnel junction layer 14, and also since the spacer layer 15N between an active layer and an n-type tunnel junction layer, which has a higher refractive index than the n-type cladding layer 13N, is provided between the second active layer 112 and the tunnel junction layer 14, the intensity of light is prevented from being completely dampened in the interspace between the p-type cladding layer 13P and the tunnel junction layer 14 as well as the interspace between the n-type cladding layer 13N and the tunnel junction layer 14, whereby an independent occurrence of two separate vertical modes can be suppressed. Therefore, despite the single mode, a laser beam with an even higher amount of power can be obtained.

The relationship of the magnitude of the power of the laser beam with the amount of electric current passed between the first electrode 191 and the second electrode 192 has been determined by calculation for the two-dimensional photonic crystal surface emitting laser 10 according to the first embodiment. The calculation approximately assumed that the injected electric current was focused into an area having a diameter of 1 mm ("current-injected region") in the first active layer 111 and the second active layer 112, the radiation coefficient of the two-dimensional photonic crystal layer 12 was 10 cm⁻¹, and the coefficient of the absorption loss in the tunnel junction layer 14 was 1000 cm⁻¹. As a comparative example, the calculation was additionally performed for a two-dimensional photonic crystal surface emitting laser which had only one active layer and no tunnel junction layer 14, with the current-injected region having a diameter of 1 mm and the two-dimensional photonic crystal layer 12 having the radiation coefficient of 10 cm⁻¹ as in the case of the first embodiment.

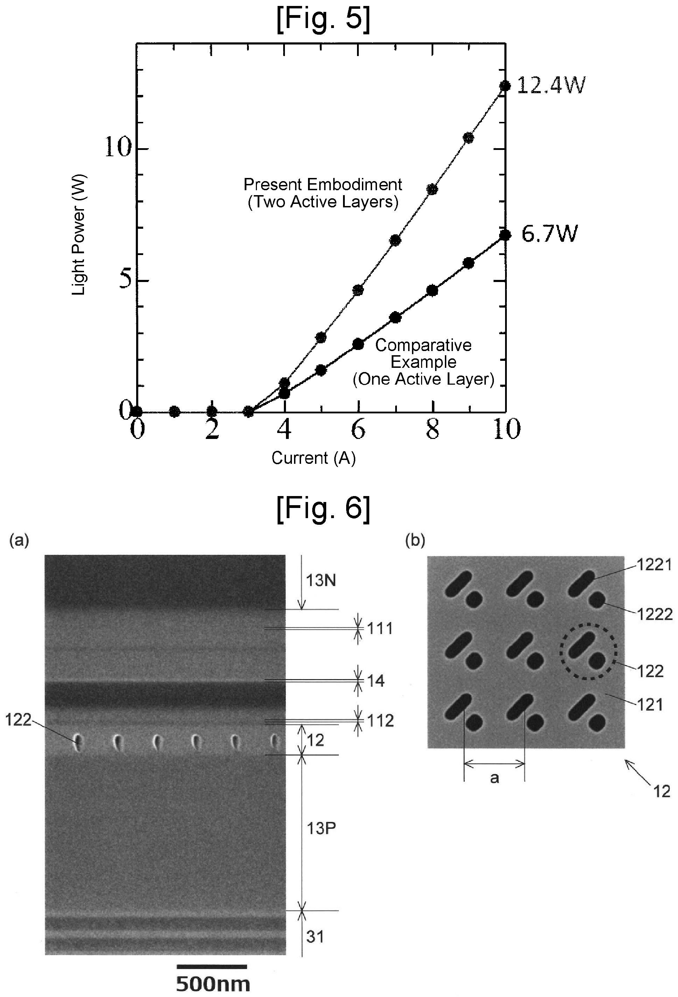

The calculated results for the first embodiment and the comparative example are shown in Fig. 5. From those results, it can be recognized that the power obtained in the first embodiment was higher than in the comparative example over the entire range of the amount of electric current considered in the calculation.

Next, an experiment was conducted in which the light power was measured for a two-dimensional photonic crystal surface emitting laser 10 actually created according to the first embodiment (the two-dimensional photonic crystal surface emitting laser 10 created for this experiment is hereinafter called the "created example of the present embodiment"). In this experiment, the diameter of the current-injected region was set to be 3 mm. This means a nine-fold increase in the area of the current-injected region as compared to the case of the calculation shown in Fig. 5. Fig. 6(a) shows an electron micrograph of a vertical section of the created example of the present embodiment. Additionally, Fig. 6(b) shows an electron micrograph of the two-dimensional photonic crystal layer 12 in the created example of the present embodiment taken from the upper side before the creation of the neighboring spacer layer 163. The created example of the present embodiment includes a distributed Bragg reflector (DBR) 31 between the p-type cladding layer 13P and the second electrode 192 in addition to the layers shown in Fig. 1. The DBR 31 consists of a layer made of Al_{0.1}Ga_{0.9}As and a layer made of Al_{0.9}Ga_{0.1}As alternately stacked, with each of the two types of layers having a thickness equal to a quarter of the wavelength which the light having the previously mentioned predetermined frequency (3.19×10¹⁴ sec⁻¹) will have in the layer concerned. The DBR 31 is provided so that, among the rays of laser light generated in the two-dimensional photonic crystal layer 12, a ray of light traveling toward the second electrode 192 is reflected by the DBR and is ultimately extracted from the window of the first electrode 191. The materials and the thicknesses of the layers other than the DBR 31 are basically identical to those shown in Table 1, although the thicknesses of the first spacer layer 161 and the second spacer layer 162 were slightly adjusted considering the shape of the modified refractive index area 122 in the two-dimensional photonic crystal layer 12.

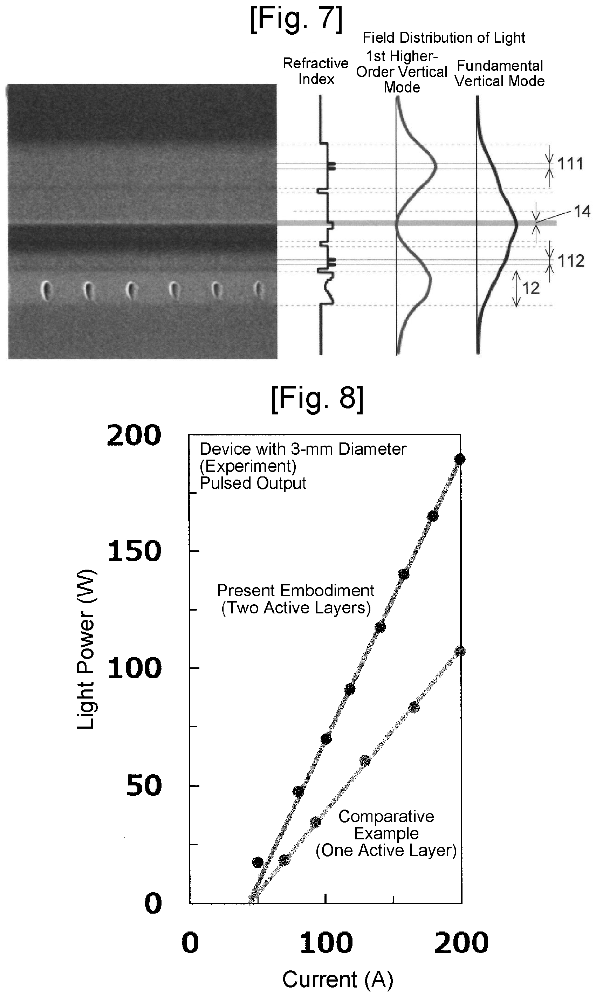

Fig. 7 shows the refractive indices of the layers in the created example of the present embodiment as well as the calculated result of the field distribution of the first higher-order vertical mode and the fundamental vertical mode of the light having the predetermined frequency, being associated with the electron micrograph of the vertical section of the created example. Since a node of the first higher-order vertical mode is formed in the vicinity of the tunnel junction layer 14, it is possible to suppress the absorption in the tunnel junction layer 14 of light having the field distribution of the first higher-order vertical mode generated in each of the first and second active layers 111 and 112. It is most likely that this contributes to the effect of producing a laser beam with a higher amount of power in the created example of the present embodiment.

Accordingly, the relationship of the magnitude of the power of the laser beam with the amount of electric current passed between the first electrode 191 and the second electrode 192 was determined by an experiment for the created example of the present embodiment. As a comparative example, another two-dimensional photonic crystal surface emitting laser which had only one active layer, with the current-injected region having a diameter of 3 mm as in the case of the created example of the present embodiment, was created and a similar experiment was also performed for this laser. Since the area of the current-injected region was larger than in the case of the calculation example shown in Fig. 5, the amount of injected electric current also needed to be larger than in the case of the same calculation example. Therefore, a pulsed electric current was supplied in the present experiment. The result of the experiment is shown in Fig. 8. This experimental result demonstrates that the created example of the present embodiment can achieve power that is approximately double the power in the comparative example.

### (3) Two-dimensional photonic crystal surface emitting laser according to second embodiment

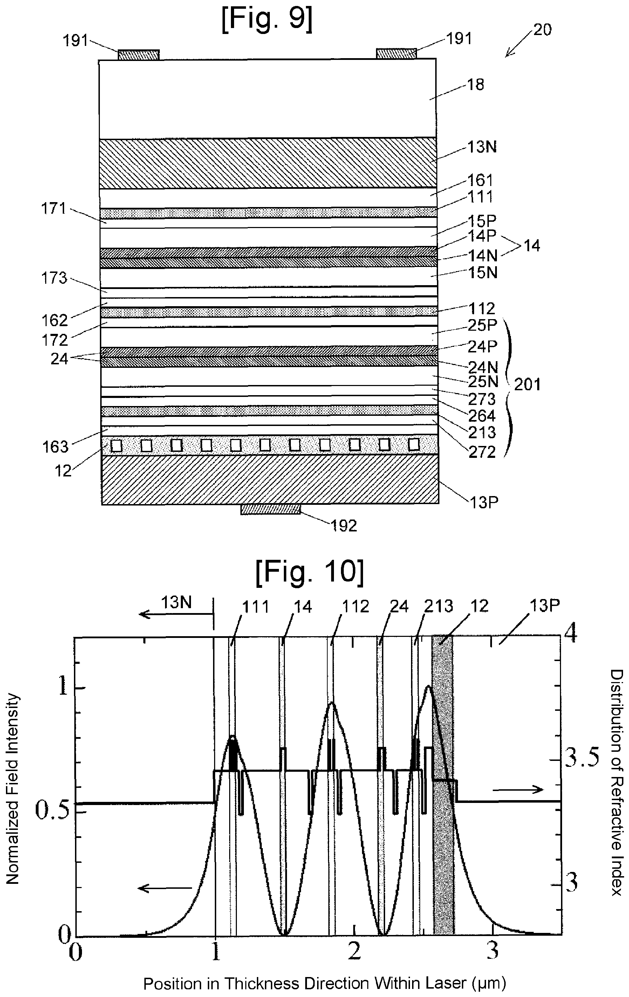

Next, a two-dimensional photonic crystal surface emitting laser 20 according to the second embodiment of the present invention is described using Figs. 9 and 10. The two-dimensional photonic crystal surface emitting laser 20 according to the second embodiment has a configuration in which the layers denoted by reference sign 201 in Fig. 9 are added between the second electron-blocking layer 172 and the two-dimensional photonic crystal layer 12 in the two-dimensional photonic crystal surface emitting laser 10 according to the first embodiment. Specifically, the following layers are sequentially added as viewed from the second electron-blocking layer 172: a second spacer layer 25P between an active layer and a p-type tunnel junction layer, a second p-type tunnel junction layer 24P, a second n-type tunnel junction layer 24N, a second spacer layer 25N between an active layer and an n-type tunnel junction layer, a second positive-hole-blocking layer 273, a fourth spacer layer 264, a third active layer 213, and a third electron-blocking layer 272. The added layers respectively have similar functions to the spacer layer 15P between an active layer and a p-type tunnel junction layer, the p-type tunnel junction layer 14P, the n-type tunnel junction layer 14N, the spacer layer 15N between an active layer and an n-type tunnel junction layer, the positive-hole-blocking layer 173, the second spacer layer 162, the second active layer 112, and the second electron-blocking layer 172. It should be noted that the second spacer layer 25P between an active layer and a p-type tunnel junction layer, the second spacer layer 25N between an active layer and an n-type tunnel junction layer, the second positive-hole-blocking layer 273, the fourth spacer layer 264, and the third electron-blocking layer 272 may be omitted, as with the aforementioned layers having similar functions to those layers. The combination of the second p-type tunnel junction layer 24P and the second n-type tunnel junction layer 24N is called the "second tunnel junction layer 24".

For this two-dimensional photonic crystal surface emitting laser 20, a simulation for determining the thicknesses of the layers was performed so that (the electric field of) light having the same predetermined frequency as in the first embodiment (3.19×10¹⁴ sec⁻¹) would be confined between the n-type cladding layer 13N and the p-type cladding layer 13P as well as have two nodes between these cladding layers, with the tunnel junction layer 14 and the second tunnel junction layer 24 arranged relative to those two nodes so that each layer is located at a position closer to the corresponding node than to an antinode of the field distribution. The result of the simulation is shown in Fig. 10, and the thicknesses of the layers are shown in Table 2. It should be noted that the thicknesses of the layers corresponding to those of the first embodiment were changed from the values in the first embodiment according to the result of the simulation.

**[Table 2]**

| | Thickness (nm) |
|---|---|
| n-type cladding layer 13N | 1000 |
| First spacer layer 161 | 120 |
| First active layer 111 | 80 |
| First electron-blocking layer 171 | 25 |
| Spacer layer between active layer and p-type tunnel junction layer, 15P | 250 |
| p-type tunnel junction layer 14P | 20 |
| n-type tunnel junction layer 14N | 20 |
| Spacer layer between active layer and n-type tunnel junction layer, 15N | 162 |
| Positive-hole-blocking layer 173 | 25 |
| Second spacer layer 162 | 120 |
| Second active layer 112 | 80 |
| Second electron-blocking layer 172 | 25 |
| Second spacer layer between active layer and p-type tunnel junction layer, 25P | 283 |
| Second p-type tunnel junction layer 24P | 20 |
| Second n-type tunnel junction layer 24N | 20 |
| Second spacer layer between active layer and n-type tunnel junction layer, 25N | 60 |
| Second positive-hole-blocking layer 273 | 25 |
| Fourth spacer layer 264 | 120 |
| Third active layer 213 | 80 |
| Third electron-blocking layer 272 | 25 |
| Third spacer layer 163 | 50 |
| Two-dimensional photonic crystal layer 12 | 170 |
| p-type cladding layer 13P | 1000 |

In the two-dimensional photonic crystal surface emitting laser 20 according to the second embodiment, when a voltage which is negative at the first electrode 191 and positive at the second electrode 192 is applied, electrons and positive holes are supplied to all of the first active layer 111, second active layer 112 and third active layer 213 due to the same reason as explained in the first embodiment. Consequently, light having a frequency band including the predetermined frequency is generated in all of the three active layers. This light forms a second higher-order vertical mode of field distribution in the thickness direction. Since the tunnel junction layer 14 and the second tunnel junction layer 24 are each located at a position closer to a node than to an antinode of that field distribution, the absorption of light in those layers will be suppressed. The light thus generated in the three active layers is amplified in the two-dimensional photonic crystal layer 12 to produce a laser beam with a higher amount of power than can be obtained with the conventional two-dimensional photonic crystal surface emitting laser as well as the one according to the first embodiment.

Fig. 10 additionally shows the distribution of the refractive index in the thickness direction. The refractive indices in the vicinities of the tunnel junction 14 and the second tunnel junction layer 24 are higher than in the n-type cladding layer 13N and the p-type cladding layer 13P. This prevents the intensity of light in the interspaces between the active layers and the tunnel junction layers from being completely dampened and thereby suppresses the lasing in a plurality of independent vertical modes.

The present invention is not limited to the previous embodiments but can be modified in various forms.

For example, the materials of the layers in the previous embodiments are not limited to the previously mentioned materials - it is possible to use various kinds of semiconductors if their polarities (p-type or n-type) are consistent with the previous descriptions. The thicknesses of the layers can also be changed within a range where the number of nodes formed by the electric field of light as well as the positional relationship between the tunnel junction layers and the nodes are similar to those of the previous embodiments.

The number of active layers in the previous embodiments was assumed to be two or three, with one tunnel junction layer provided in the former case and two tunnel junction layers in the latter case. It is possible to provide four or more active layers. In that case, the number of tunnel junction layers to be provided should be fewer than that of the active layers by one.

### [Modes]

It is evident to a person skilled in the art that the previously described illustrative embodiments are specific examples of the following modes of the present invention.

(Clause 1) A two-dimensional photonic crystal surface emitting laser according to one mode of the present invention includes:
a) a plurality of active layers arranged separately from each other in the thickness direction, each of the active layers configured to emit light which covers a frequency band including a predetermined frequency by being injected with an electric current;
b) a p-type cladding layer made of a p-type semiconductor and an n-type cladding layer made of an n-type semiconductor, with the plurality of active layers sandwiched in between;
c) a tunnel junction layer provided between each neighboring pair of layers among the plurality of active layers, the tunnel junction layer formed by a p-type tunnel junction layer and an n-type tunnel junction layer, where the p-type tunnel junction layer is made of a p-type semiconductor having a higher carrier concentration than the p-type semiconductor forming the p-type cladding layer, and the n-type tunnel junction layer is made of an n-type semiconductor joined to a p-type-cladding-layer side of the p-type tunnel junction layer and having a higher carrier concentration than the n-type semiconductor forming the n-type cladding layer;
d) a two-dimensional photonic crystal layer provided between the p-type cladding layer and the n-type cladding layer, the two-dimensional photonic crystal layer including a plate-shaped base body in which modified refractive index areas which are areas having a refractive index different from the refractive index of the base body are arranged, where the modified refractive index areas are periodically arranged in a two-dimensional form with a period corresponding to the wavelength of the light having the predetermined frequency in the two-dimensional photonic crystal layer; and
e) a pair of electrodes between which the p-type cladding layer and the n-type cladding layer are sandwiched,
where:
f) the distance between the p-type cladding layer and the n-type cladding layer as well as the material of each of the aforementioned layers are set so that the light having the predetermined frequency forms a higher-order vertical mode field distribution which is confined between the p-type cladding layer and the n-type cladding layer and has the same number of nodes as the number of tunnel junction layers; and
g) each of the tunnel junction layers is located at a position closer to a node between the p-type cladding layer and the n-type cladding layer than to an antinode of the higher-order vertical mode field distribution.

(Clause 2) The two-dimensional photonic crystal surface emitting laser according to Clause 2, which is a two-dimensional photonic crystal surface emitting laser according to Clause 1, further includes a spacer layer located at least at one of the interspaces between the active layers and the tunnel junction layer.

(Clause 3) In the two-dimensional photonic crystal surface emitting laser according to Clause 3, which is a two-dimensional photonic crystal surface emitting laser according to Clause 2, the refractive index of the spacer layer is higher than the refractive indices of the p-type cladding layer and the n-type cladding layer.

(Clause 4) The two-dimensional photonic crystal surface emitting laser according to Clause 4, which is a two-dimensional photonic crystal surface emitting laser according to Clause 2 or 3, further includes a spacer layer located at least at one position other than the interspaces between the active layers and the tunnel junction layer.

(Clause 5) In the two-dimensional photonic crystal surface emitting laser according to Clause 5, which is a two-dimensional photonic crystal surface emitting laser according to one of Clauses 1-4, the plurality of active layers are made of the same material and have the same thickness.

(Clause 6) In the two-dimensional photonic crystal surface emitting laser according to Clause 6, which is a two-dimensional photonic crystal surface emitting laser according to one of Clauses 1-5, the thickness of the tunnel junction layer is within a range from 10 to 200 nm.

### REFERENCE SIGNS LIST

10, 20 ... Two-Dimensional Photonic Crystal Surface Emitting Laser
111 ... First Active Layer
112 ... Second Active Layer
12 ... Two-Dimensional Photonic Crystal Layer
121 ... Base Body
122 ... Modified Refractive Index Area
1221 ... First Modified Refractive Index Area
1222 ... Second Modified Refractive Index Area
13N ... n-type Cladding Layer
13P ... p-type Cladding Layer
14 ... Tunnel Junction Layer
14N ... n-type Tunnel Junction Layer
14P ... p-type Tunnel Junction Layer
15N ... Spacer Layer Between Active Layer and n-type Tunnel Junction Layer
15P ... Spacer Layer Between Active Layer and p-type Tunnel Junction Layer
161-163, 264 ... Spacer Layer
171 ... First Electron-Blocking Layer
172 ... Second Electron-Blocking Layer
173 ... Positive-Hole-Blocking Layer
18 ... Substrate
191 ... First Electrode
192 ... Second Electrode
201 ... Layers Added to Two-Dimensional Photonic Crystal Surface Emitting Laser of First Embodiment in Second Embodiment
213 ... Third Active Layer
24 ... Second Tunnel Junction Layer
24N ... Second n-type Tunnel Junction Layer
24P ... Second p-type Tunnel Junction Layer
25N ... Second Spacer Layer Between Active Layer and n-type Tunnel Junction Layer
25P ... Second Spacer Layer Between Active Layer and p-type Tunnel Junction Layer
272 ... Third Electron-Blocking Layer
273 ... Second Positive-Hole-Blocking Layer
31 ... Distributed Bragg Reflector (DBR)

## Claims

1. A two-dimensional photonic crystal surface emitting laser, comprising:
a) a plurality of active layers arranged separately from each other in a thickness direction, each of the active layers configured to emit light which covers a frequency band including a predetermined frequency by being injected with an electric current;
b) a p-type cladding layer made of a p-type semiconductor and an n-type cladding layer made of an n-type semiconductor, with the plurality of active layers sandwiched in between;
c) a tunnel junction layer provided between each neighboring pair of layers among the plurality of active layers, the tunnel junction layer formed by a p-type tunnel junction layer and an n-type tunnel junction layer, where the p-type tunnel junction layer is made of a p-type semiconductor having a higher carrier concentration than the p-type semiconductor forming the p-type cladding layer, and the n-type tunnel junction layer is made of an n-type semiconductor joined to a p-type-cladding-layer side of the p-type tunnel junction layer and having a higher carrier concentration than the n-type semiconductor forming the n-type cladding layer;
d) a two-dimensional photonic crystal layer provided between the p-type cladding layer and the n-type cladding layer, the two-dimensional photonic crystal layer including a plate-shaped base body in which modified refractive index areas which are areas having a refractive index different from a refractive index of the base body are arranged, where the modified refractive index areas are periodically arranged in a two-dimensional form with a period corresponding to a wavelength of the light having the predetermined frequency in the two-dimensional photonic crystal layer; and
e) a pair of electrodes between which the p-type cladding layer and the n-type cladding layer are sandwiched,
where:
f) a distance between the p-type cladding layer and the n-type cladding layer as well as a material of each of the aforementioned layers are set so that the light having the predetermined frequency forms a higher-order vertical mode field distribution which is confined between the p-type cladding layer and the n-type cladding layer and has a same number of nodes as a number of tunnel junction layers; and
g) each of the tunnel junction layers is located at a position closer to a node between the p-type cladding layer and the n-type cladding layer than to an antinode of the higher-order vertical mode field distribution.

2. The two-dimensional photonic crystal surface emitting laser according to claim 1, further comprising a spacer layer located at least at one of interspaces between the active layers and the tunnel junction layer.

3. The two-dimensional photonic crystal surface emitting laser according to claim 2, wherein a refractive index of the spacer layer is higher than refractive indices of the p-type cladding layer and the n-type cladding layer.

4. The two-dimensional photonic crystal surface emitting laser according to claim 2 or 3, further comprising a spacer layer located at least at one position other than the interspaces between the active layers and the tunnel junction layer.

5. The two-dimensional photonic crystal surface emitting laser according to one of claims 1-3, wherein the plurality of active layers are made of a same material and have a same thickness.

6. The two-dimensional photonic crystal surface emitting laser according to one of claims 1-3, wherein a thickness of the tunnel junction layer is within a range from 10 to 200 nm.
